(19) Europäisches Patentamt
European Patent Office
Office européen des brevets

(11) Veröffentlichungsnummer : **0 579 701 B1**

(12) # EUROPÄISCHE PATENTSCHRIFT

(45) Veröffentlichungstag der Patentschrift :
**26.07.95 Patentblatt 95/30**

(51) Int. Cl.$^6$ : **H05K 3/42,** C25D 5/54

(21) Anmeldenummer : **92908857.3**

(22) Anmeldetag : **13.04.92**

(86) Internationale Anmeldenummer :
**PCT/DE92/00311**

(87) Internationale Veröffentlichungsnummer :
**WO 92/19091 29.10.92 Gazette 92/27**

(54) **VERFAHREN ZUR METALLISIERUNG VON NICHTLEITERN, INSBESONDERE LEITERPLATTEN, UNTER VERWENDUNG VON STICKSTOFFHALTIGEN QUARTÄRSALZEN IN DEM VERFAHREN.**

(30) Priorität : **12.04.91 DE 4112462**

(43) Veröffentlichungstag der Anmeldung :
**26.01.94 Patentblatt 94/04**

(45) Bekanntmachung des Hinweises auf die Patenterteilung :
**26.07.95 Patentblatt 95/30**

(84) Benannte Vertragsstaaten :
**AT DE ES FR GB IT NL SE**

(56) Entgegenhaltungen :
**EP-A- 0 213 542**
**WO-A-89/10431**
**WO-A-91/03920**

(73) Patentinhaber : **ATOTECH Deutschland GmbH**
**Erasmusstrasse 20-24**
**D-10553 Berlin (DE)**

(72) Erfinder : **GRAPENTIN, Hans-Joachim**
**Wundtstr. 17**
**D-1000 Berlin 19 (DE)**
Erfinder : **NATUSCH, Andreas**
**Grossbeerenstr. 21**
**D-1000 Berlin 42 (DE)**
Erfinder : **TIEMANN, Norbert**
**Platanenallee 24**
**D-1000 Berlin 19 (DE)**

(74) Vertreter : **Effert, Udo, Dipl.-Ing.**
**Patentanwalt**
**Radickestrasse 48**
**D-12489 Berlin (DE)**

EP 0 579 701 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Metallisierung von Nichtleitern.

Verfahren zur Herstellung von Nichtleitern, insbesondere durchkontaktierter Leiterplatten, sind innerhalb des Standes der Technik bekannt. Innerhalb der Schrift DE-PS 37 41 459 wird ein Verfahren beschrieben, bei dem katalytisch aktivierte Oberflächen des Basismaterials erzeugt werden und bei dem die katalytisch aktivierten Oberflächen vor der galvanischen Metallabscheidung konditioniert werden. Diese Konditionierung erfolgt mit einer Lösung, enthaltend eine oder mehrere stickstoffhaltige organische Verbindungen. Die Lehre dieser Schrift beinhaltet ebenfalls die Aktivierung mittels edelmetallhaltiger, kolloidaler, ionogener oder nicht ionogener Katalysatoren, insbesondere die bekannten Katalysatoren auf Basis von Palladium oder Zinn.

Innerhalb der Schrift DE-OS 39 28 832 wird ein Verfahren zur Herstellung durchkontaktierter Leiterplatten mit Resist, sowie Verfahren zur Herstellung derselben beschrieben. Dieses Verfahren arbeitet jedoch ohne Anwendung von edelmetallhaltigen, kolloidalen, ionogenen oder nicht ionogenen Katalysatoren.

Desweiteren beschreiben die DE-PS 38 06 884 und PCT/DE 91/00920 (WO 91/08324) Verfahren zur Direktmetallisierung von Nichtleiteroberflächen durch die Anwendung einer Behandlung mit Oxidationsmitteln, beispielsweise Kaliumpermanganat, und einer Heterocyclen-Lösung, beispielsweise Pyrrol-Lösung. Bei der Durchführung dieses Verfahrens scheidet sich auf der Nichtleiteroberfläche ein leitfähiges organisches Polymer, beispielsweise Polypyrrol, ab. Diese polymere leitfähige Schicht haftet fest auf der Oberfläche des Nichtleiters und kann sofort galvanisch metallisiert werden.

Gemäß der Lehre dieser Schriften kann eine leitfähige Polymerschicht auf Nichtleitern nur dann erzeugt werden, wenn vorher eine haftende Schicht von Oxidationsmitteln aufgebracht wird. Üblicherweise bedient man sich der Methode, daß der Nichtleiter mit einer alkalischen Permanganatlösung behandelt wird, wobei insbesondere bei Verwendung eines Epoxids als Nichtleiter dieses oxidiert wird und auf der Oberfläche eine Mangandioxidschicht ausgebildet wird, die wiederum als Oxidationsmittel zur Bildung von leitfähigen Polymeren dient (bei Kontaktierung mit Heterocyclen).

Nicht alle Materialien, so beispielweise Cyanatester, höher vernetzte Epoxide mit höherem Tg als 140 °C, Epoxide mit BT-Zusätzen, Teflon, bestimmte Polyimide und Polyamide, Polystyrole, Polyethylene, Polycarbonate, Blockpolymerisate aus Acrylnitril-Butadien-Styrol (ABS), Polyester oder Polysulfone, oder auch Füllstoffe wie Glas, Keramik, Aluminiumoxid, Titandioxid oder Bariumsulfat bilden direkt und problemlos mit der Permanganatlösung eine Schicht von Braunstein. Es besteht somit innerhalb des Standes der Technik der Bedarf, auch diese Materialien problemlos bearbeiten zu können.

Aufgabe der Erfindung ist es, ein Verfahren bereitzustellen, bei dem eine gleichmäßige und homogene Metallisierung in der kürzesten Zeit, insbesondere in den Bohrhülsen, erreicht werden kann und das sich zur Bearbeitung fast aller üblichen Nichtleitermaterialien eignet.

Gelöst wird diese Aufgabe gemäß der Lehre der Patentansprüche.

Das erfindungsgemäße Verfahren zur Metallisierung von Nichtleitern zeichnet sich durch die aufeinander folgenden Verfahrensschritte aus:

a) Behandlung des Nichtleiters mit einer Lösung eines stickstoffhaltigen Quartärsalzes und/oder eines Chelatbildners,

b) Behandlung des Nichtleiters mit einer manganat- und/oder permanganathaltigen Lösung,

c) Behandlung des Nichtleiters mit einer sauren heterocyclenhaltigen Lösung, insbesondere Pyrrollösung,

d) elektrolytische Metallisierung des Nichtleiters.

Gegebenenfalls kann vor Schritt a) eine Behandlung des Nichtleiters mit einem Reiniger und/oder Ätzreiniger erfolgen.

Es hat sich herausgestellt, daß das erfindungsgemäße Verfahren mit Vorteil in horizontalen Durchlaufanlagen, die kontinuierlich betrieben werden, verwendet werden kann.

Innerhalb des erfindungsgemäßen Verfahrens lassen sich als Reiniger und/oder Ätzreiniger alle handelsüblichen Produkte verwenden. Mit Vorteil finden solche Lösungen Anwendung, die Persulfat und/oder Säure enthalten, insbesondere Natriumpersulfat und Mineralsäure, wie z.B. Schwefelsäure.

Die Behandlung des Nichtleiters gemäß Verfahrensschritt b) findet mit einer Lösung eines stickstoffhaltigen Quartärsalzes oder eines Chelatbildners statt.

Als stickstoffhaltige Quartärsalze können die in der DE-PS 35 30 617 als Konditionierungsmittel für Basismaterialien beschriebenen Stoffe verwendet werden. Es handelt sich hierbei bevorzugt um Quartärsalze N-alkenylsubstituierter cyclischer organischer Stickstoffverbindungen oder Gemische oder Polymere dieser Quartärsalze und besonders um Verbindungen, die eine Vinyl- oder Allylgruppe enthalten.

Bevorzugt sind Verbindungen der allgemeinen Formel:

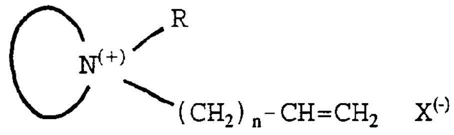

(I)

worin
R = Wasserstoff, $C_1$ - $C_4$-Alkyl, Hydroxymethyl, 1-Hydroxyethyl oder 2-Hydroxyethyl,
n = 0 oder 1,
und $X^{(-)}$ das Anion einer anorganischen oder organischen Säure bedeuten.

Der Ring kann beispielsweise ein Pyrrolidon-, Imidazolin-, ε-Caprolactam- oder Benzimidazolring sein. Besonders geeignet im erfindungsgemäßen Sinne sind N-Methyl-N'-vinylimidazoliumsalze (z.B. Methosulfat), N-Methyl-N-vinylpyrrolidoniumsalze (z.B. Chlorid), N-Butyl-N'-allylbenzimidazoliumsalze (z.B. Methosulfat), N-Methyl-N'-allylimidazoliumiodid, N-Methyl-N'-vinyl-ε-caprolactam-Quartärsalze oder deren über Vinyl- oder Allylgruppen polymerisierte homo- oder copolymerisierte Verbindungen, z.B. Copolymerisat aus N-Methyl-N'-vinylimidazoliummethochlorid und Vinylpyrrolidon.

Als Chelatbildner eignen sich beispielsweise Ethanolamin, Triethanolamin oder harte Komplexbildner, wie EDTA.

Die Wirkung der erfindungsgemäß zu verwendenden Verbindungen kann überraschenderweise gesteigert werden, wenn diese in Kombination mit anderen organischen Stickstoffverbindungen, wie z.B. aliphatischen Aminosäuren (Glycin, Sarkosin, Hippursäure, usw.) (DE-OS 31 49 919) verwendet werden. Es konnte festgestellt werden, daß ein Zusatz dieser Verbindungen in Konzentrationen von 1-50 g/l die Konditionierungswirkung steigert.

Die gleichzeitige Anwesenheit eines waschaktiven Netzmittels im Konditionierungsmittel ist ebenso möglich. Als Netzmittel kann bevorzugt Alkylphenolpolyglykolether eingesetzt werden. Auch kann der Reinigungsvorgang durch Ultraschallunterstützung mit der Konditionierung kombiniert werden kann.

Die Lösung der stickstoffhaltigen Quartärsalze oder Chelatbildner wird bei Temperaturen von etwa 10 bis 90°C, vorzugsweise 40 bis 70°C angewendet, jedoch hat die Arbeitstemperatur keinen nennenswerten Einfluß auf die konditionierende Wirkung zur Mangandioxidfilmbildung.

Das erfindungsgemäße Verfahren läßt sich mit Vorteil bei der direkten Metallisierung von Nichtleitern einsetzen. Dabei wird dem aus einer wässrigen, gegebenenfalls Lösungsvermittler enthaltenden Lösung von noch nicht leitfähigen Oligomeren oder Monomeren oder Oligomer-Monomer-Gemischen aus der Gruppe der 5-gliedrigen Heterocyclen durch Kontakt mit an Nichtleitern adsorbierten Oxidationsmitteln an der Oberfläche ein fest haftendes, unlösliches Hochpolymerprodukt abgeschieden.

Als weiterer Verfahrensschritt schließt sich die Behandlung mit einer manganat- und/oder permanganathaltigen Lösung an. In der Regel findet eine Lösung Anwendung, die Manganat in der Konzentration 10 - 75 g/l, Permanganat in einer Konzenztration von 30 - 150 g/l, sowie Natriumhydroxid in einer Konzentration von 40 - 70 g/l enthält. Es ist aber auch möglich, Lösungen zu verwenden, die nur Manganat oder nur Permanganat enthalten. Die Behandlung mit Manganat/Permanganatlösung kann auch im sauren Medium, insbesondere schwachsauren Medium, erfolgen.

Der nächste Verfahrensshcritt ist die Behandlung mit einer schwachsauren Pyrrollösung. Der pH-Wert einer solchen Lösung liegt in der Regel zwischen pH 1,5 - 4,00.

Die anschließende galvanische Metallabscheidung erfolgt mittels bekannter galvanischer Bäder. Es können prinzipiell alle Metalle bzw. Legierungen abgeschieden werden, die auf galvanischem Wege abzuscheiden sind. Bevorzugt werden jedoch Kupferelektrolyte verwendet. Besonders bevorzugt sind schwefelsaure Kupferbäder mit einem Gehalt von 50 - 300 g/l Schwefelsäure oder einem Metallgehalt von 5 - 50 g/l. Aber auch fluorborsaure, salzsaure thiosulfat- oder pyrophosphathaltige oder cyanidische Elektrolyte, sowie Elektrolyte auf Basis von Sulfonamiden und organischen Sulfonsäuren haben sich als gut geeignet erwiesen.

Elektrolyte werden unter den üblichen Bedingungen, nämlich im Temperaturbereich zwischen 20 und 70° C, mit Stromdichten zwischen 0,1 und 20 A/$dm^2$ betrieben. Überraschenderweise kann die Zeit der galvanischen Abscheidung erheblich verkürzt werden, nämlich in besonders günstigen Fällen auf < 2 min. Man erhält gleichmäßige, geschlossene und darüberhinaus fest haftende Metallschichten, die auch im sogenannten Durchlichttest keinerlei Fehlstellen aufweisen.

Die erfindungsgemäß hergestellten durchkontaktierten Schaltungen können in bekannter Weise verarbeitet werden. So kann beispielsweise ein weiterer Aufbau von metallischen Schichten auf galvanischem Weg erfolgen, so daß Kupferschichten von 25 - 40 µm entstehen, die anschließend mit weiteren metallischen Schichten belegt werden, die als Ätzresiste auf die Leiterplatten aufgebracht werden.

Mit dem erfindungsgemäßen Verfahren können Nichtleiter auf Basis von Epoxid-Hartpapier, Epoxid-Glas

oder Kombinationen von beiden (CEM 1), Spezialepoxid (CEM 3), Phenolharz (FR2), Polyimid, Polyamid, Polystyrol, Polyethylen, Polyvinylchlorid, Polycarbonat, Acrylat, Acrylnitril-Butadien-Styrol-Blockpolymerisat (ABS), Polyester, Polysulfon, Teflon, Cyanatester, Epoxid mit BT-Zusätzen, Aluminiumoxid, Glas oder Keramik beschichtet werden.

Die folgenden Beispiele sollen die Erfindung näher erläutern:

BEISPIEL 1

Eine gebohrte , kupferkaschierte Leiterplatte, wobei der Nichtleiter (das Basismaterial) aus normal vernetztem Epoxid mit Glas als Füllstoff besteht, wird einem Rückatzungsverfahren ("Smear Removal"), wie es bei Mehrlagenschaltungen üblich ist, ausgesetzt. Die Rückätzung ist davon unabhängig, ob es sich um einen Plasma-, Permanganat-, Schwefelsäure-, Chromsäureprozeß oder einen entsprechenden Kombinationsprozeß handelt.

Die Bohrungen der so vorbehandelten Leiterplatte, bei der Epoxid zurückgeätzt und der Füllstoff Glas freigelegt wurde, wird nach folgendem Verfahren metallisiert:

| | Zeit | Temp. |
|---|---|---|
| 1. Ätzreinigen (z.B. auf der Basis Natriumpersulfat/Schwefelsäure) | 0,5 min | 30°C |
| Spülen | | |
| 2. Reinigen (ohne Konditionierung) pH etwa 12 | 0,5 min (0,5-5 min) | 70°C |
| Spülen | | |
| 3. Oxidationsfilmbildung mit Hilfe einer alkalischen Permanganatlösung (pH > 12,9) (60 g/l $KMnO_4$ und 25 g/l $K_2MnO_4$) | 2,5 min (0,5-5 min) | 85°C |
| Spülen | | |

| | | |
|---|---|---|
| 4. Leitschichtbildung mittels einer stabilisierten monomeren/ oligomeren Pyrrollösung (pH 2) Spülen | 0,5 min (0,5-5 min) | 25°C |
| 5. Kupferreinigung (5 Vol. %ige Schwefelsäure) | 0,5 min (0,5-3 min) | 25°C |
| 6. Elektrolytische Metallisierung* z.B. mit einem sauren Kupferelektrolyten Spülen/Trocknen | | 27°C |

* In den Beispielen wurde zur Vereinfachung die Stromdichte konstant bei 2 A/dm² gehalten . Als Reiniger wurde ein konventioneller, für Epoxid geeigneter, der aber keine der beschriebenen Verbindungen mit konditionierenden Eigenschaften enthält, verwendet.

Nach einer 30minütigen elektrolytischen Verkupferung, das entspricht einer Kupferabscheidung von etwa 10 µm , konnte keine 100prozentige Belegung, vor allem der Glasfaser, festgestellt werden. Dieses Ergebnis konnte auch dann nicht verbessert werden, wenn der Reiniger im pH-Wert vom alkalischen über neutralen bis hin zum sauren Bereich variiert wurde.

BEISPIEL 2

Wie Beispiel 1, aber mit einer Konditionierung nach folgendem Arbeitsablauf:

| | | |
|---|---|---|
| 1. Ätzreinigen 200 g/l Natriumpersulfat + 15 ml/l Schwefelsäure, 96 Gew.-% Spülen | 0,5 min | 30° C |

| | | | |
|---|---|---|---|
| 2. | Reinigen/Konditionieren (pH 11 - 12)<br>5 g/l Natriumcarbonat<br>+ 0,05 g/l Basotronic PVI®<br>(Imidazoliumverbindung)<br>Spülen | 0,5 min | 70° C |
| 3. | Kaliumpermanganatlösung<br>50 g/l $KMnO_4$<br>25 g/l $K_2MnO_4$<br>55 g/l NaOH<br>Spülen | 0,5 min | 87° C |
| 4. | Leitschichtbildung<br>mittels einer stabilisierten<br>monomeren/oligomeren Pyrrollösung<br>(pH 2)<br>Spülen | 0,5 min | 5° C |
| 5. | Schwefelsäuredekapierung (5-vol.-%ig) | 0,5 min | 25° C |
| 6. | Elektrolytische Metallisierung<br>mit einem sauren Kupferbad<br>Spülen / Trocknen | | 30° C |

Bereits nach einer dreiminütigen elektrolytischen Verkupferung war eine 100%ige Belegung erreicht.

BEISPIEL 3

Beispiel 2 wurde wiederholt unter Verwendung von 500 mg/Liter der Konditionierungskomponente. Die Belegung war 100%ig nach einer Kupferschichtdicke von etwa 10 µm.

BEISPIEL 4

Beispiel 2 wurde wiederholt unter Verwendung von 2 g/Liter Basotronic PVI®.

Eine 100%ige Belegung der Bohrlöcher, einschließlich der Glasfaserfüllstoffe, war bereits nach einer 15minütigen elektrolytischen Kupferverstärkung, das entspricht etwa einer Kupferschichtstärke von 5µm, erreicht.

BEISPIEL 5

Beispiel 2 wurde wiederholt unter Verwendung von 5 g/Liter der Konditionierungskomponente. Die Belegung war bereits 100%ig nach einer Kupferverstärkung auf etwa 3µm (10minütiger Abscheidungszeit bei 2 $A/dm^2$).

BEISPIEL 6

Beispiel 2 wurde wiederholt unter Verwendung von 20 g/Liter Poly-N-Methyl-N′-vinylimidazoliummethosulfat.
Eine geschlossene Verkupferung der Bohrungen war bereits nach einer 5minütigen Verkupferung bei 2 $A/dm^2$ erreicht, d.h. nach einer Kupferschichtstärke von etwa 1,5 μm.

BEISPIEL 7

Beispiel 4 wurde wiederholt, wobei dem Reiniger zusätzlich 10 g/Liter Glycin (Aminoessigsäure) zugesetzt wurden.
Es konnte eine verbesserte Konditionierung festgestellt werden, da die Kupferbelegung bereits nach einer Schichtdicke von 3μm 100%ig war.

BEISPIEL 8

Die Beispiele 2-7 wurden wiederholt unter Verwendung eines neutralen Reinigers, unter Zusatz der entsprechenden Konzentrationen einer quaternären organischen Stickstoffverbindung auf Basis von Poly-N-Methyl-N′-vinylimidazoliummethosulfat, einschließlich des Zusatzes an Glycin.
Die Versuchsbefunde entsprechen den in den Beispielen 2-7 aufgeführten Ergebnissen.

BEISPIEL 9

Beispiel 8 wurde wiederholt unter Verwendung eines stark sauren Reinigers (pH < 1) mit den jeweiligen Zusätzen an Konditionierungsmitteln.
Auch hier wurden Metallisierungsverbesserungen festgestellt.

BEISPIEL 10

Die Beispiele 2-9 wurden wiederholt unter Verwendung einer sauren Permanganatlösung als Oxidationsfilmbildner (s.Punkt 3 im Metallisierungsverfahren).
Auch hier wurden durch die jeweiligen Vorkonditionierungen verbesserte Metallisierungsergebnisse festgestellt.

BEISPIEL 11

Beispiel 10 wurde wiederholt mit einer "Starrflex-Schaltung", d.h. einer Nichtleiterkombination aus Epoxid, Glas und Acrylkleber.
Hier wirkt die konditionierende Wirkung der Kombination nach Beispiel 4 am besten. Die Belegung aller drei Nichtleiter ist nach etwa 8 μm 100%ig.

BEISPIEL 12

Beispiele 4-7 wurden unter Verwendung folgender Nichtleiter: Phenolharz (FR2), Epoxid-Hartpapier (FR3), Kombination aus Epoxid/Glas und Epoxid-Hartpapaier (CEM1), Spezialepoxid (CEM3), Polyimid, Polyamid, Acrylnitril-Butadien-Styrol Blockpolymerisat (ABS), Polysulfon mit analogen Ergebnissen wiederholt.

BEISPIEL 13

Beispiel 4 wurde wiederholt, wobei die Leiterplatte aus kupferkaschiertem, gebohrtem Cyanatester mit Glasfasern als Füllstoff bestand.
Eine gut und gleichmäßige Mangandioxid- und damit auch leitfähige Polymerbildung, die später elektrolytisch 100%ig metallisierbar war, konnte nach einer Kupferschichtdicke von 5μm erreicht werden, nachdem dem Reiniger 50 g/Liter N-Methyl-N′-vinylimidazoliummethosulfat und 10 g/Liter Aminoessigsäure zugesetzt wurden.

BEISPIEL 14

Beispiele 4 und 7 wurden wiederholt, wobei der Nichtleiter aus Epoxid mit einem sogenannten "BT-Zusatz"

bestand. Dieses Material, welches außerdem Glas als Füllstoff enthält, weist sich als hochvernetzt aus und ist chemisch nur schwer angreifbar (der Blasübergangspunkt Tg liegt bei etwa 180°C). Deshalb konnte nach Beispiel 1 keine Oxidfilmbildung erreicht werden.
Nach Beispiel 4 war die Metallisierung nach einer Kupferschichtdicke von 10µm, nach Beispiel 7 einer Schichtdicke von 5 µm 100%ig.

BEISPIEL 15

In diesem Beispiel wurde versucht, auf Teflon, Glas, Keramik und Aluminiumoxiden einen Oxidfilm in einer alkalischen Permanganatlösung zu erhalten, der dann zur Bildung von leitfähigen Polymeren (nach Beispiel 1) führt und leitzlich elektrolytisch metallisierbar wäre.
Brauchbare Metallisierungen wurden erhalten, wenn ein Reiniger bei pH 12 mit:
100 g/Liter Poly-N-Methyl-N'-vinylimidazoliummethosulfat und
50 g/Liter Glycin (Aminoessigsäure) verwendet und die jeweiligen Nichtleiter 5 Minuten bei 80°C behandelt wurden.

BEISPIEL 16

Die Beispiele 2-15 wurden sowohl im Tauchen, Schwallen und Fluten mit und ohne Ultraschall durchgeführt.
Die konditionierende Wirkung konnte in allen Fällen festgestellt werden.

BEISPIEL 17

Da die Qualität der elektrolytischen Metallisierung von Nichtleitern von der Gleichmäßigkeit der leitfähigen Polymerschicht und diese wiederum von der Oxidfilmbildung (Mangandioxid) abhängig ist, wurden von den Beispielen 1-16 jeweils Proben auf die Mangankonzentrationen nach der Methode der energiedispersiven Röntgenanalyse untersucht.
Bei der Verwendung der erfindungemäßen Konditionierungsmittel wurden jeweils höhere Mangankonzentrationen ermittelt.

**Patentansprüche**

1. Verfahren zur Metallisierung von Nichtleitern mit den aufeinanderfolgenden Verfahrensschritten:
   a) Behandlung des Nichtleiters mit einer Lösung eines Chelatbildners und/oder eines stickstoffhaltigen Quartärsalzes,
   b) Behandlung des Nichtleiters mit einer manganat- und/oder permanganathaltigen Lösung,
   c) Behandlung des Nichtleiters mit einer monomeren und/oder oligomeren, sauren Pyrrollösung,
   d) elektrolytische Metallsierung des Nichtleiters.

2. Verfahren gemäß Anspruch 1, dadurch gekennzeichnet, daß stickstoffhaltige Quartärsalze von N-alkenylsubstituierten cyclischen organischen Stickstoffverbindungen oder Gemische oder Polymere dieser Quartärsalze verwendet werden.

3. Verfahren gemäß Anspruch 2, dadurch gekennzeichnet, daß als Quartärsalze der N-alkenylsubstituierten cyclischen organischen Stickstoffverbindungen Verbindungen der allgemeinen Formel I

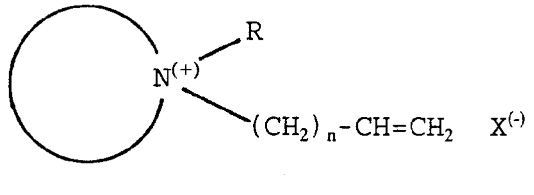

(I)

worin
R = Wasserstoff, $C_1$ - $C_4$-Alkyl, Hydroxymethyl, 1-Hydroxyethyl oder 2-Hydroxyethyl,
n = 0 oder 1,

und $X^{(-)}$ das Anion einer anorganischen oder organischen Säure bedeuten, eingesetzt werden.

4. Verfahren gemäß Anspruch 3, dadurch gekennzeichnet, daß die Quartärsalze der N-alkenylsubstituierten cyclischen organischen Stickstoffverbindungen einen Pyrrolidon-, Imidazol-, ε-Caprolactam- oder Benzimidazolring enthalten.

5. Verfahren gemäß Anspruch 4, wobei als Quartärsalze der N-alkenylsubstituierten cyclischen organischen Stickstoffverbindungen N-Methyl-N'-vinylimidazoliumsalze, N-Methyl-N'-vinylpyrrolidoniumsalze, N-Vinylimidazoliumsalze, N-Butyl-N'-allylbenzimidazoliumsalze oder deren über Vinyl- oder Allylgruppen polymerisierte homo- oder copolymerisierte Verbindungen eingesetzt werden.

6. Verfahren gemäß Anspruch 1, dadurch gekennzeichnet, daß als Chelatbildner Ethanolamin, Triethanolamin oder Ethylendiamintetraessigsäure (EDTA) verwendet werden.

7. Verfahren nach mindestens einem der Ansprüche 1 bis 6, dadurch gekennzeichnet, daß die im Verfahrensschritt a) eingesetzte Lösung Quartärsalze der N-alkenylsubstituierten cyclischen organischen Stickstoffverbindung oder der Gemische oder Polymere dieser Quartärsalze oder Chelatbildner in Konzentrationen von 0,5 g bis 100 g pro Liter enthält.

8. Verfahren nach Anspruch 7, dadurch gekennzeichnet, daß die im Verfahrensschritt a) eingesetzte Lösung zusätzlich ein Netzmittel enthält.

9. Verfahren nach Anspruch 8, dadurch gekennzeichnet, daß als Netzmittel Alkylphenolpolyglykolether verwendet werden.

10. Verfahren nach mindestens einem der Ansprüche 1 bis 9, dadurch gekennzeichnet, daß Nichtleiter auf Basis von Epoxid-Hartpapier, Epoxid-Glas oder Kombinationen von beiden, Spezialepoxid, Phenolharz, Polyimid, Polyamid, Polystyrol, Polyethylen, Polyvinylchlorid, Polycarbonat, Acrylat, Acrylnitril-Butadien-Styrol-Blockpolymerisat, Polyester, Polysulfon, Teflon, Cyanatester, Epoxid mit BT-Zusätzen, Aluminiumoxid, Glas oder Keramik metallisiert werden.

## Claims

1. Method of metallising non-conductors, having the following method steps:
   a) treating the non-conductor with a solution of a chelating agent and/or a nitrogen-containing quaternary salt;
   b) treating the non-conductor with a manganate- and/or permanganate-containing solution;
   c) treating the non-conductor with a monomeric and/or oligomeric, acidic pyrrole solution; and
   d) electrolytically metallising the non-conductor.

2. Method according to claim 1, characterised in that nitrogen-containing quaternary salts of N-alkenyl-substituted, cyclic, organic nitrogen compounds or mixtures or polymers of these quaternary salts are used.

3. Method according to claim 2, characterised in that compounds of the general formula I

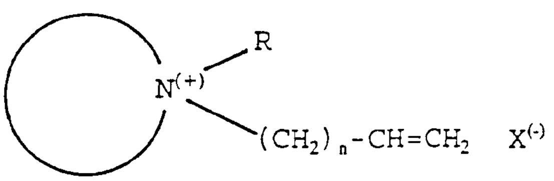

(I)

are used as the quaternary salts of the N-alkenyl-substituted, cyclic, organic nitrogen compounds, wherein
R = hydrogen, $C_1$ - $C_4$-alkyl, hydroxymethyl, 1-hydroxyethyl or 2-hydroxyethyl;
n = 0 or 1;
and $X^{(-)}$ is the anion of an inorganic or organic acid.

4. Method according to claim 3, characterised in that the quaternary salts of the N-alkenyl-substituted, cyclic, organic nitrogen compounds contain a pyrrolidone ring, an imidazole ring, an ε-caprolactam ring or a benzimidazole ring.

5. Method according to claim 4, wherein N-methyl-N'-vinylimidazolium salts, N-methyl-N'-vinylpyrrolidonium salts, N-vinylimidazolium salts, N-butyl-N'-allylbenzimidazolium salts or their homo- or co-polymerised compounds, which are polymerised by vinyl or allyl groups, are used as the quaternary salts of the N-alkenyl-substituted, cyclic, organic nitrogen compounds.

6. Method according to claim 1, characterised in that ethanolamine, triethanolamine or ethylene diamine tetra-acetic acid (EDTA) are used as the chelating agents.

7. Method according to at least one of claims 1 to 6, characterised in that the solution used in method step a) contains quaternary salts of the N-alkenyl-substituted, cyclic, organic nitrogen compound or of the mixtures or polymers of these quaternary salts or chelating agents in concentrations of 0.5 g to 100 g per litre.

8. Method according to claim 7, characterised in that the solution used in method step a) additionally contains a wetting agent.

9. Method according to claim 8, characterised in that alkylphenolpolyglycol ethers are used as the wetting agents.

10. Method according to at least one of claims 1 to 9, characterised in that non-conductors based on epoxide hard paper, epoxide glass or combinations of both, special epoxide, phenol resin, polyimide, polyamide, polystyrene, polyethylene, polyvinyl chloride, polycarbonate, acrylate, acrylonitrile-butadienestyrene block polymer, polyester, polysulphone, Teflon, cyanate ester, epoxide with BT additions, aluminium oxide, glass or ceramics are metallised.

## Revendications

1. Procédé de métallisation de non conducteurs comprenant les étapes successives suivantes :
   a) Traitement du non conducteur par une solution d'un chélateur et/ou d'un sel quaternaire contenant de l'azote,
   b) traitement du non conducteur par une solution contenant du manganate et/ou du permanganate,
   c) traitement du non conducteur par une solution de pyrrol acide monomérique et/ou oligomérique,
   d) métallisation électrolytique du non conducteur.

2. Procédé selon la revendication 1, caractérisé en ce que l'on utilise des sels quaternaires, contenant de l'azote, des composés azotés organiques cycliques substitués N-alkényle ou des mélanges ou des polymères de ces sels quaternaires.

3. Procédé selon la revendication 2, caractérisé en ce que l'on utilise, en tant que sels quaternaires des composés azotés organiques cycliques substitués N-alkényle, des composés répondant à formule générale I

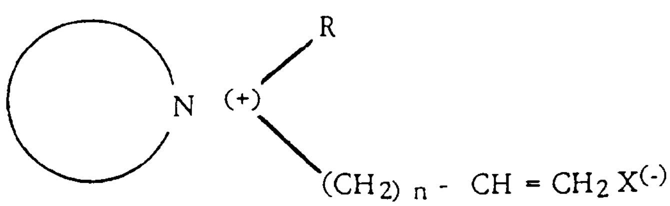

(I)

où

R = hydrogène, $C_1$ - $C_4$-alkyle, hydroxyméthyl, 1-hydroxyéthyl ou 2-hydroxyéthyl,
n = 0 ou 1,
et $X^{(-)}$ est l'anion d'un acide inorganique ou organique.

4. Procédé selon la revendication 3, caractérisé en ce que les sels quaternaires des composés azotés organiques cycliques substitués N-alkényle comportent un composé cyclique de pyrrolidone, d'imidazole, de ε-caprolactame ou de benzimidazole.

5. Procédé selon la revendication 4, caractérisé en ce que l'on utilise, en tant que sels quaternaires des composés azotés organiques cycliques substitués N-alkényle, des sels de N-méthyl-N′-vinylimidazole, des sels de N-méthyl-N′-vinylpyrrolidone, des sels de N-vinylimidazole, des sels de N-butyl-N′-allylbenzimidazole ou leurs composés homopolymérisés ou copolymérisés polymérisés par l'intermédiaire de groupes vinyle ou allyle.

6. Procédé selon la revendication 1, caractérisé en ce que l'on utilise, en tant que chélateurs, de l'éthanolamine, de la triéthanolamine ou de l'acide éthylènediamine-tétracétique (EDTA).

7. Procédé selon au moins l'une quelconque des revendications 1 à 6, caractérisé en ce que la solution utilisée dans l'étape a) du procédé comprend des sels quaternaires du composé azoté organique cyclique substitué N-alkényle ou bien des mélanges ou des polymères desdits sels quaternaires ou encore des chélateurs dans des concentrations comprises entre 0,5 et 100 g par litre.

8. Procédé selon la revendication 7, caractérisé en ce que la solution utilisée dans l'étape a) du procédé comprend par ailleurs un agent mouillant.

9. Procédé selon la revendication 8, caractérisé en ce que l'on utilise, en tant qu'agent mouillant, de l'alkylphénolpolyglycoléther.

10. Procédé selon au moins l'une quelconque des revendications 1 à 9, caractérisé en ce que l'on métallise des non conducteurs à base de papier dur époxy, de verre époxy ou de combinaisons de ceux-ci, de résine époxy spéciale, de résine phénolique, de polyimide, de polyamide, de polystyrène, de polyéthylène, de polychlorure de vinyle, de polycarbonate, d'acrylate, de bloc polymère à base acrylonitril-butadène-styrène, de polyester, de polysulfone, de Téflon, d'ester de cyanate, de résine époxy avec additifs BT, d'oxyde d'aluminium, de verre ou de céramique.